# EUROPEAN PATENT APPLICATION

(11) **EP 2 175 289 A1**
(43) Date of publication of application: **14.04.2010**
(21) Application number: 08165963.3
(22) Date of filing: 07.10.2008
(51) Int. Cl.: G01R 33/36, G01R 33/422, G01R 33/34

(54) **Nuclear magnetic resonance component comprising an electromagnetic shielding**

(71) Applicant: Koninklijke Philips Electronics N.V., 5621 BA Eindhoven (NL)
(72) Inventor: The designation of the inventor has not yet been filed
(74) Representative: Damen, Daniel Martijn

(57) **Abstract**

The invention relates to an electronic nuclear magnetic resonance component adapted for being operated within the magnet bore (610) of a magnetic resonance system, the electronic component comprising an electric circuit (202) and an electromagnetic shielding (106; 402), the electromagnetic shielding being arranged for electromagnetically shielding the electric circuit (202), wherein the electromagnetic shielding comprises a shielding material, the shielding material comprising a conductive material with a surface resistance higher than the surface resistance of copper.

## Description

### TECHNICAL FIELD

The invention relates to an electronic nuclear magnetic resonance component, a magnetic resonance receiver coil unit, a method of manufacturing an electronic nuclear magnetic resonance component and a computer program product.

### BACKGROUND AND RELATED ART

Magnetic resonance imaging (MRI) is a state of the art imaging technology which allows cross-sectional viewing of objects like the human body with unprecedented tissue contrast. MRI is based on the principles of nuclear magnetic resonance (NMR), a spectroscopic technique used by scientists to obtain microscopic chemical and physical information about molecules. The basis of both NMR and MRI is the fact, that atomic nuclei with non-zero spin have a magnetic moment. In medical imaging, usually nuclei of hydrogen atoms are studied since they are present in the body in high concentrations like for example water. The nuclear spin of elementary particles can resonate at a resonance frequency, if a strong DC magnetic field is applied. This magnetic resonance (MR) frequency is determined by the level of the magnetic flux. In an MRI scanner, the magnetic field matches a selected resonance frequency only at one position in space. Only at this position the presence of these particles can be detected. By varying the position step by step, an image can be measured.

The needed strong DC magnetic field (B₀ field) is typically generated by superconducting magnets. In order to vary the field, such that it matches a given radio frequency only at one position in space, a field gradient is generated using gradient coils. The field gradient can vary over time to achieve a scan. The frequency range in the gradient coils is low and reaches up to a maximum of 10 kHz.

To excite nuclear resonances, the RF coil generates a high frequency magnetic field and a nuclear resonance. Typical resonance frequencies are in the range from 42 MHz to 128 MHz, corresponding to magnetic flux levels in the range of 1 T to 3 T.

To measure nuclear resonances, 'sensor' or 'receiver' coil units are placed close to the region of interest, e.g. on the patient. These receiver coil units may comprise various electronic components. Especially, modem digital MR (magnetic resonance) receiver coil units comprise active switching digital electronics, wherein the digital switching activity creates magnetic fields that are in the RF frequency band to which the receive coil itself is sensitive. These 'spurious signals' will therefore be detected by the RF coil and will cause distortions of the image that is reconstructed in an MRI system using the coil output signal.

As a consequence, RF shielding is necessary to prevent a pick up of these spurious signals by the receive coil. This can be achieved by for example encasing the electronics into a closed copper box which then acts as a Faraday cage electromagnetically shielding the outside of the box from the spurious signals. A closed copper box however will be influencing the switching gradient fields that are used for spatial encoding of the RF signals. Eddy currents are induced in the conducting structures of the Faraday cage according to the Faraday's law of induction. These Eddy currents will distort the magnetic field generated within the magnet bore and thus cause distortions of the MR image to be reconstructed. Moreover, the Eddy currents will cause heat dissipation thus constituting a risk of skin bum off for example a patient located in close vicinity of the coil unit.

The maximum accepted amount of distortion due to the shielded box is given by the system specifications of the MRI scanner. Typically distortions should be kept < 10%.

To achieve this with a normal completely closed RF shield one would either have to keep the enclosure very small or increase the distance of the enclosure to the patient to an unacceptable value.

For example, WO 2006/00928 discloses a radio frequency receive coil for receiving a magnetic resonance signal including a radio frequency antenna, the radio frequency antenna including one or more electrical conductors, at least one of which is a substantially hollow conductor, wherein at least one electrical component is disposed inside a substantially hollow conductor.

### SUMMARY OF THE INVENTION

The present invention provides an electronic nuclear magnetic resonance component adapted for being operated within the magnet bore of a magnetic resonance system, the electronic component comprising an electric circuit and an electromagnetic shielding, the electromagnetic shielding being arranged for electromagnetically shielding the electric circuit, wherein the electromagnetic shielding comprises as shielding material a tin compound or in general any other conductive material having a higher, preferably "big surface resistance" as compared to copper. For example, in order to provide an effective shielding, the shielding material is arranged in a laminar or sheetlike structure. Further, preferably, the shielding material is a tin alloy or the shielding material comprises homogenously distributed tin particles. Within the framework of this patent application, an electronic nuclear magnetic resonance component is an electronic component for use in a MRI-environment, notably within the magnetic field of the MR-system.

The usage of such a conductive material like for example a tin compound as electromagnetic shielding material has the advantage that in an optimal manner a compromise between the requirements of good RF shielding and highly efficient Eddy current suppression can be provided. Using a material that has lower conductivity would decrease the amount of Eddy currents that are generated. However, since a decrease of Eddy currents is linear with the decrease of the conductivity, the RF shielding effectiveness which is a function of the RF penetration depth, i.e. the skin effect would also decrease. The RF shielding effectiveness is a function of the square root of the surface resistance, which means that a decrease of Eddy currents is a function of the square root of the resistance when maintaining the same RF shielding effectiveness. For example, if the resistance is nine times bigger the gradient influence will be three times less maintaining the same RF shielding effectiveness.

In accordance with an embodiment of the invention, the shield comprises a support layer, wherein the conductive material is adapted as a shielding layer, wherein the shielding layer is arranged on the support layer. The usage of a support layer has the advantage that the thickness of the shielding layer comprising the conductive material can be made extremely thin. Preferably, the thickness of the shielding layer is in between 20-30 µm. As a consequence, by means of the support layer a self supporting structure with high mechanical stability can be provided.

In accordance with a further embodiment of the invention, the shielding further comprises a copper layer, the copper layer being arranged between the support layer and the shielding layer. The additional usage of a copper layer has the advantage, that the shielding layer comprising the conductive material can be easily attached to the support layer. Tin has an excellent adhesion to copper such that an additional usage of fixation components in order to attach the shielding layer to the support layer is not required.

The thickness of the copper layer should be < 1 µm in order not to take away the advantage of the high resistance of the tin layer.

Preferably, the support layer and the shielding layer form a printed circuit board, such that by applying state of the art printed circuit board manufacturing techniques, a cheap production of such an electromagnetic shielding can be provided. For a production process, for example a layer of copper can be bonded to the entire support layer, followed by the additional step of adhering the shielding layer to the copper layer.

Also preferably, in accordance with an embodiment of the invention the electric circuit is also arranged on the support layer of the printed circuit board. For example, the printed circuit board may carry the shielding layer and the optional copper layer on its front side, whereas on its backside it carries the electric circuit. Again, it is possible to manufacture such an electronic nuclear magnetic resonance component by means of standard printed circuit board production techniques in a cheap and fast, as well as reliable manner.

In accordance with a further embodiment of the invention, the printed circuit board is a multilayer printed circuit board, wherein the electric circuit is arranged in a layer of the multilayer printed circuit board. This has the advantage, that the electric circuit can for example be encased by two shielding layers such that a space consuming design of a box like Faraday cage in which the electric circuits are arranged is not required anymore. Also, such kind of multilayer printed circuit board can be manufactured with standard printed circuit board manufacturing techniques, with the restriction that a layer comprising the electric circuit is arranged in between two shielding layers comprising as shielding material the conductive material.

In another aspect, the invention relates to a magnetic resonance receiver coil unit, the unit comprising an electric component according to the invention. For example, the receiver coil unit is a digital or even wireless receiving coil unit, wherein in the following it is understood that a receiving coil unit comprises the receiving coils itself, as well as various kinds of electronics like amplifiers, filters, digitizers etc.

In another aspect, the invention relates to a method of manufacturing an electronic nuclear magnetic resonance component adapted for being operated within the magnet bore of a magnetic resonance system, the electronic component comprising an electric circuit and an electromagnetic shielding, the electromagnetic shielding being arranged for electromagnetically shielding the electric circuit, wherein the electromagnetic shielding comprises as shielding material a conductive material with a surface conductivity higher than the surface conductivity of copper, the method comprising providing the electric unit and applying the electromagnetic shielding.

In accordance with an embodiment of the invention, the electric circuit and the electromagnetic shielding are manufactured by means of printed circuit board manufacturing techniques.

In another aspect, the invention relates to a computer program product comprising computer executable instructions to perform the method of manufacturing an electronic nuclear magnetic resonance component adapted for being operated within the magnet bore of a magnetic resonance system.

### BRIEF DESCRIPTION OF THE DRAWINGS

In the following preferred embodiments of the invention are described in greater detail by way of example only making reference to the drawings in which:
Fig. 1 is a schematic illustrating an electromagnetic shielding,
Fig. 2 is a schematic illustrating an electromagnetic shielding comprising a copper layer and an electric circuit,
Fig. 3 is a further schematic illustrating an electromagnetic shielding comprising a copper layer and an electric circuit,
Fig. 4 is a schematic illustrating a shielding box comprising an electric circuit,
Fig. 5 is a schematic illustrating a multilayer printed circuit board,
Fig. 6 is a block diagram illustrating a magnetic resonance imaging system.

### DETAILED DESCRIPTION

In the following similar elements are depicted by the same reference numerals.

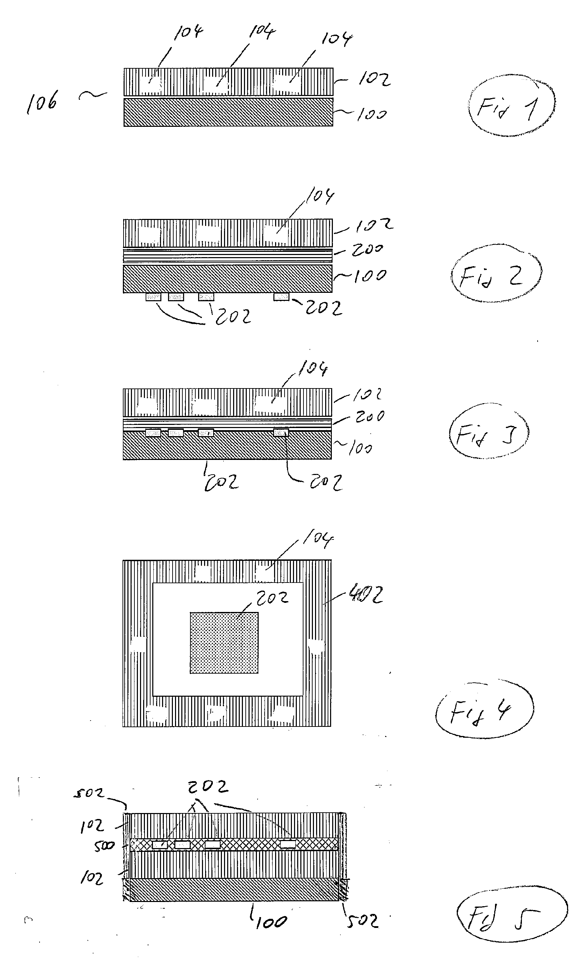

Fig. 1 is a schematic illustrating an electromagnetic shielding 106. The electromagnetic shielding 106 consists of a support layer 100, on top of which a shielding layer 102 is arranged. The shielding layer comprises as shielding material a conductive material with a surface conductivity higher than the surface conductivity of copper. For example, the shielding layer may consist of a tin alloy, a tin compound or a tin-zinc compound. The support layer 100 may for example consist of a plastics material.

The shielding layer 102 further comprises a set of slits 104 which may additionally be bridged with capacitors. However, the usage of slits bridged by capacitors is an option that should only be used in cases where an extremely high reduction of Eddy currents is required at cost of a reduced RF shielding effectiveness.

The electromagnetic shielding is designed as a box like Faraday cage enclosing an electric circuit to shield the electric circuit from electromagnetic RF field irradiation.

Fig. 2 is a further schematic illustrating an electromagnetic shielding, wherein in fig. 2 in addition to the electromagnetic shielding 106 illustrated in fig. 1 a copper layer 200 is shown. The copper layer is arranged in between the shielding layer 102 and the support layer 100. As already mentioned above, the purpose of the copper layer is to provide a good adhesion of the shielding layer 102 to the support 100.

Further shown in fig. 2 are electric circuits 202, wherein the electric circuits 202 are arranged on one side of the support 100 and wherein the copper layer 200 and the shielding layer 102 are arranged on another side of the support layer 100 opposite to the side on which the electric circuits 202 are arranged. Such an arrangement shown in fig. 2 can be easily manufactured by standard printed circuit board manufacturing techniques known in the art.

Fig. 3 is a further schematic illustrating an electronic nuclear magnetic resonance component, wherein the difference between fig. 2 and fig. 3 is, that in fig. 3 the electric circuits 202 are arranged in between the support layer 100 and the copper layer 200. By means of such an arrangement, the electric circuit is encased by the copper layer 200 and the support layer 100 and thus well protected against any kind of environmental influences.

Fig. 4 is a schematic illustrating a Faraday cage formed by an electromagnetic shielding 402. The electromagnetic shielding encases in a three dimensional manner an electric circuit 202. Further, the electromagnetic shielding may comprise slits 104. The electromagnetic shielding 402 illustrated in fig. 4 is electromagnetically shielding the electric circuit 202 and comprises as shielding material a conductive material with a surface conductivity higher than the surface conductivity of copper.

Fig. 5 is a further schematic illustrating an electronic nuclear magnetic resonance component adapted for being operated within the magnet bore or the magnetic resonance system. The component consists of a multilayer printed circuit board, wherein subsequent layers are given as follows by a support layer 100, followed by a shielding layer 102, followed by a circuit layer 500, which is followed by another shielding layer 102. The circuit layer 500 comprises electric circuits for example required for operating a magnetic resonance receiver. For this purpose, the circuit layer may have additional electrical connections to other electronic MR receiver and system components.

The circuit layer 500 is completely enclosed by the shielding layers 102 forming a Faraday cage. As a consequence, the circuit layer is electromagnetically shielded in a three dimensional manner. Further, due to the usage of a conductive material as the shielding material in the shielding layer 102, the induction of Eddy currents by switching gradient fields is minimized.

The formation of the Faraday cage in which the circuit layer 500 comprising the electric circuits 202 is encased can also be seen from fig. 5: on top of the support layer 100, the shielding layer 102 is arranged, wherein the shielding layer 102 completely covers the support layer 100. On top of the shielding layer 102, the circuit layer 500 is arranged, wherein in the edge areas 502 of the underlying shielding layer 102 the circuit layer 500 is confined by material of the shielding layer 102. The purpose is, that also in a horizontal direction an effective electromagnetic shielding can be provided. On top of the circuit layer 500, the next shielding layer 102 is arranged, wherein this shielding layer 102 covers the circuit layer 500, as well as its edged areas 502 formed by the shielding material.

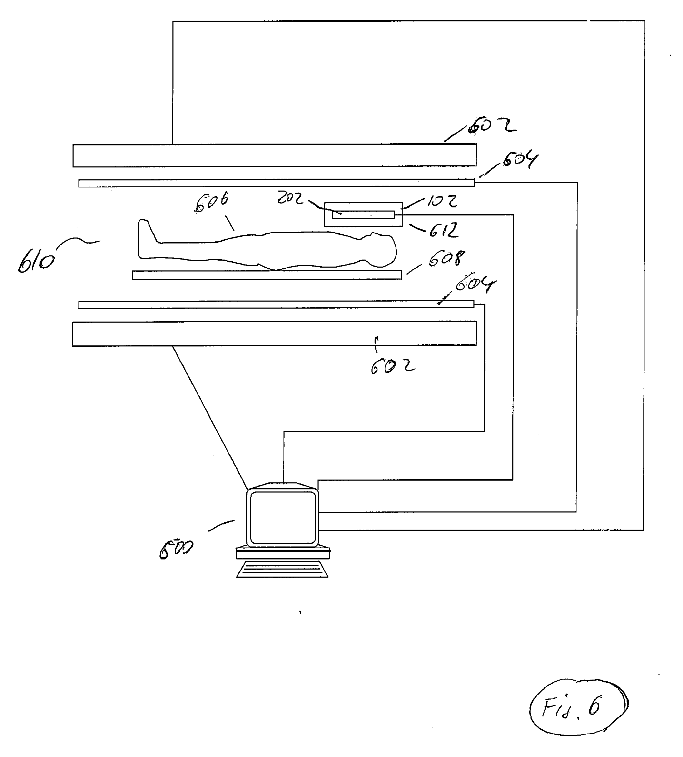

Fig. 6 is a block diagram illustrating a schematic of a nuclear magnetic resonance imaging system. Only major components of a preferred MRI system which incorporate the present invention are shown in fig. 6. The magnetic resonance imaging system comprises a data processing system 600 adapted for controlling components of the MRI system, like for example the main field of a magnet 602 and gradient coils 604. The main field coils 602 and the gradient field coils 604 form a magnet bore 610 of the magnetic resonance imaging system.

As further illustrated in fig. 6, inside the magnet bore 610 a moveable table 608 is arranged, on which, for example a patient 606 or in general an object to be imaged is arranged.

For imaging purposes, the data processing system 600 is connected to a receiver coil unit 612. For imaging purposes, for example by means of an RF generator an RF pulse sequence is generated under the control of the data processing system 600 and for example protons ¹H in the body 606 of a person are excited in a predefined manner. The resulting magnetic resonance imaging signal is then detected by the coil unit 612. For this purpose, the coil unit 612 comprises a reception coil for acquiring the magnetic resonance imaging signal, as well as various kinds of electronic components and electronic circuits 202 used for amplification of the acquired RF signal and used for transmission of the acquired RF signal, for example in a digital manner to the data processing system 600.

In order to prevent a distortion of the acquired RF signal by RF signals generated by the electric circuits 202, the electric circuit 202 is encased in an electromagnetic shielding 102. As already explained above, preferably the electromagnetic shielding 102 comprises as shielding material a conductive material with a surface conductivity higher than the surface conductivity of copper, which has the advantage, that Eddy currents induced by switching gradients generated by the gradient coils 604 are minimized. A minimization of the Eddy currents ensures, that distortions of the magnetic field grows close to the reception coils in the magnet bore 610 due to the Eddy currents are minimized.

### LIST OF REFERENCE NUMERALS:

- 100: support layer
- 102: shielding layer
- 104: slit
- 106: shielding
- 200: copper layer
- 202: electric circuit
- 402: box
- 500: circuit layer
- 502: edge
- 600: data processing system
- 602: main B₀ coil
- 604: gradient coil
- 606: patient
- 608: moveable table
- 610: bore
- 612: RF coil unit

## Claims

1. An electronic nuclear magnetic resonance component adapted for being operated within the magnet bore (610) of a magnetic resonance system, the electronic component comprising an electric circuit (202) and an electromagnetic shielding (106; 402), the electromagnetic shielding being arranged for electromagnetically shielding the electric circuit (202), wherein the electromagnetic shielding comprises a shielding material, the shielding material comprising a conductive material with a surface resistance higher than the surface resistance of copper.

2. The component of claim 1, wherein the conductive material is a tin compound.

3. The component of claim 1 or 2, wherein the shielding comprises a support layer (100), wherein the shielding material is comprised in a shielding layer (102), wherein the shielding layer (102) is arranged on the support layer (100).

4. The component of claim 3, wherein the shielding further comprises a copper layer (200), the copper layer (200) being arranged between the support layer (100) and the shielding layer (102).

5. The component of claim 3 or 4, wherein the support layer (100) and the shielding layer (102) form a printed circuit board

6. The component of claim 5, wherein the electric circuit (202) is arranged on the support layer (100) of the printed circuit board.

7. The component of claim 6, wherein the printed circuit board is a multilayer printed circuit board, wherein the electric circuit (202) is arranged in a layer of the multilayer printed circuit board.

8. The component of any of the previous claims 3 to 7, wherein the electric circuit (202) is arranged between two shielding layers (102).

9. The component of any of the previous claims, wherein the thickness of the shielding layer (102) is between 5 and 50 µm, preferably between 20 and 30 µm.

10. A magnetic resonance receiver coil unit (612), the unit comprising an electronic component according to any of the previous claims 1 to 9.

11. A method of manufacturing an electronic nuclear magnetic resonance component adapted for being operated within the magnet bore (610) of a magnetic resonance system, the electronic component comprising an electric circuit (202) and an electromagnetic shielding (106; 402), the electromagnetic shielding being arranged for electromagnetically shielding the electric circuit (202), wherein the electromagnetic shielding comprises a shielding material, the shielding material comprising a conductive material with a surface resistance higher than the surface resistance of copper, the method comprising:
providing the electric circuit (202),
applying the electromagnetic shielding.

12. A computer program product comprising computer executable instructions to perform any of the method steps as claimed in claim 11.
